# EUROPEAN PATENT APPLICATION

(11) **EP 1 852 744 A1**
(43) Date of publication of application: **07.11.2007**
(21) Application number: 06713780.2
(22) Date of filing: 15.02.2006
(51) Int. Cl.: G03F 7/031, G03F 7/00

(54) **PHOTOSENSITIVE LITHOGRAPHIC PRINTING PLATE MATERIAL**

(30) Priority: 25.02.2005 JP 2005050264
(71) Applicant: Konica Minolta Medical & Graphic, Inc., Tokyo 163-0512 (JP)
(72) Inventor: MATSUMURA, Toshiyuki c/o Konica Minolta Medical&Graphic, Inc., Tokyo, 1928505 (JP)
(74) Representative: Gille Hrabal Struck Neidlein Prop Roos
(86) International application number: PCT/JP2006/302639
(87) International publication number: WO 2006/090623

(57) **Abstract**

The present invention provides a light sensitive planographic printing plate material which is suitable for exposure employing a laser emitting light with an emission wavelength of from 350 to 450 nm, and which exhibits high sensitivity and storage stability, as well as excellent safelight property. The light sensitive planographic printing plate material comprises a support and provided thereon, a light sensitive layer containing a photopolymerization initiator (A), a polymerizable ethylenically unsaturated compound (B), a dye (C) having absorption maximum in the wavelength regions of from 350 to 450 nm, and a polymeric binder (D), **characterized in that** the light sensitive layer contains a compound represented by the following formula (1) as the photopolymerization initiator (A),

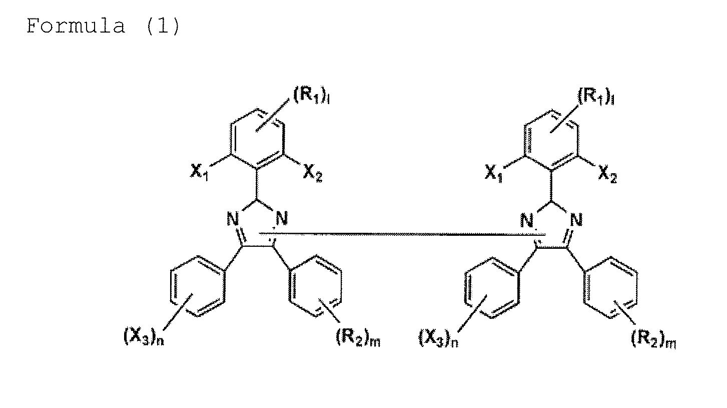

## Description

### FIELD OF THE INVENTION

The present invention relates to a light sensitive planographic printing plate material used in a computer-to-plate (hereinafter referred to as CTP) system, and particularly to a light sensitive planographic printing plate material suitable for exposure employing laser light having a wavelength of from 350 to 450 nm.

### TECHNICAL BACKGROUND

In recent years, a CTP system has been developed and put into practical use, which directly writes digital image data on a light sensitive planographic printing plate material employing laser light in a process of manufacturing a printing plate for off-set printing.

In a printing field in which relatively high printing durability is required, a negative working light sensitive planographic printing plate material is known which comprises a polymerizable light sensitive layer containing a polymerizable compound (see for example, Japanese Patent O.P.I. Publication Nos. 1-105238 and 2-127404).

A light sensitive printing plate material capable of being imagewise exposed with laser having an emission wavelength from 390 to 430 nm is known, which improves safelight property in view of handling.

A compact blue-violet laser of high output power emitting rays with a wavelength of from 390 to 430 nm can be easily obtained. A printing plate material adapted to this laser, which can be processed under room light, has been developed (see for example, Patent Document 1, 2 and 3).

There are known light sensitive planographic printing plate materials comprising a light sensitive layer containing biimidazole, which improve safelight property under yellow light (see for example, Patent Document 4).

There are known photopolymerizable compositions with high sensitivity and low sublimability containing a hexaarylbisimidazole compound having an aryl group with a substituent such as an alkyl group (see for example, Patent Document 5).

However, these printing plate materials have still problems in that safelight property is difficult to maintain while maintaining high sensitivity and sensitivity after long-term storage is lowered, which results in reduction of dot area during printing.
[Patent Document 1]
   Japanese Patent O.P.I. Publication No. 2000-35673
[Patent Document 2]
   Japanese Patent O.P.I. Publication No. 2000-98605
[Patent Document 3]
   Japanese Patent O.P.I. Publication No. 2001-264978
[Patent Document 4]
   Japanese Patent O.P.I. Publication No. 2001-194782
[Patent Document 5]
   Japanese Patent O.P.I. Publication No. 2004-137152

### DISCLOSURE OF THE INVENTION

### PROBLEMS TO BE SOLVED BY THE INVENTION

An object of the invention is to provide a light sensitive planographic printing plate material which is suitable for exposure employing a laser emitting light with an emission wavelength of from 350 to 450 nm, and which exhibits high sensitivity and storage stability, as well as excellent safelight property.

### MEANS FOR SOLVING THE ABOVE PROBLEMS

The above object has been attained by one of the following constitutions:
1. A light sensitive planographic printing plate material comprising a support and provided thereon, a light sensitive layer containing a photopolymerization initiator (A), a polymerizable ethylenically unsaturated compound (B), a dye (C) having absorption maximum in the wavelength regions of from 350 to 450 nm, and a polymeric binder (D), the light sensitive planographic printing plate material being characterized in that the light sensitive layer contains a compound represented by the following formula (1) as the photopolymerization initiator. 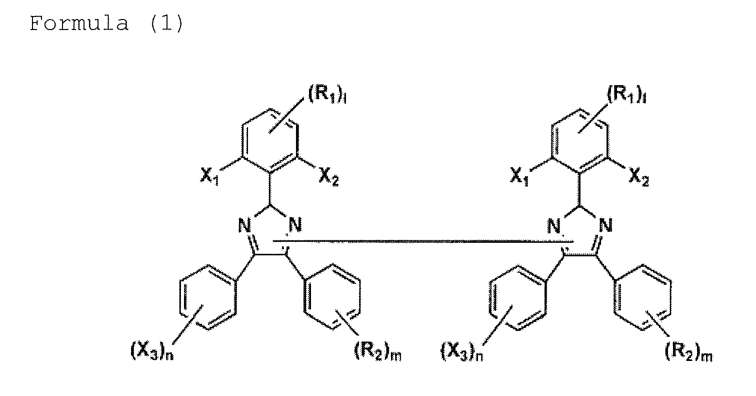
   In formula (1), X₁ and X₂ independently represent a hydrogen atom or a halogen atom, provided that at least one of X₁ and X₂ is a halogen atom; X₃ represents a halogen atom; n is an integer of from 1 to 5; R₁ represents a monovalent substituent; 1 is an integer of from 0 to 3; R₂ represents a monovalent substituent; and m is an integer of 0 or 1.
2. The light sensitive planographic printing plate material of item 1 above, wherein in formula (1) R₂ is an alkyl group or an alkoxy group.
3. The light sensitive planographic printing plate material of item 2 above, wherein in formula (1) X₁ is a chlorine atom, X₂ is a hydrogen atom, and X₃ is a chlorine atom.
4. The light sensitive planographic printing plate material of any one of items 1 through 3 above, wherein the dye (C) having absorption maximum in the wavelength regions of from 350 to 450 nm is a compound represented by the following formula (2).

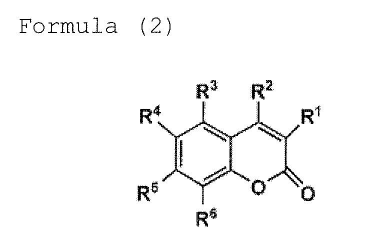

In formula (2), R¹ through R⁶ independently represent a hydrogen atom, an alkyl group, a cycloalkyl group, an aryl group, an alkenyl group, an alkinyl group, a heterocyclic group, an alkoxy group, a cycloalkoxy group, an aryloxy group, an alkylthio group, a cycloalkylthio group, an arylthio group, an alkoxycarbonyl group, an aryloxycarbonyl group, a sulfamoyl group, an acyl group, an amido group, a carbamoyl group, a ureido group, an alkylsulfonyl group, an arylsulfonyl group, an amino group, a halogen atom, a cyano group, a nitro group or a hydroxyl group.

### EFFECTS OF THE INVENTION

The present invention can provide a light sensitive planographic printing plate material which is adapted to exposure employing a laser emitting light with an emission wavelength of from 350 to 450 nm, and which exhibits high sensitivity and storage stability, as well as excellent safelight property.

### PREFERRED EMBODIMENT OF THE INVENTION

The preferred embodiment of the present invention will be explained in detail below, but the invention is not specifically limited thereto.

In the invention, a light sensitive planographic printing plate material comprising a support and provided thereon, a light sensitive layer containing a photopolymerization initiator (A), a polymerizable ethylenically unsaturated compound (B), a dye (C) having absorption maximum in the wavelength regions of from 350 to 450 nm, and a polymeric binder (D), the light sensitive planographic printing plate material being characterized in that the light sensitive layer contains a compound represented by formula (1) as the photopolymerization initiator.

Incorporation of a photopolymerization initiator represented by formula (1) in the light sensitive layer provides high sensitivity and storage stability, as well as excellent safelight property.

Components contained in the image formation layer in the invention will be explained below.

### Polymerization initiator (A)

The photopolymerization initiator in the invention is a compound which initiates polymerization of an ethylenically unsaturated compound on light exposure. In the invention, the light sensitive layer contains as a polymerization initiator a compound represented by formula (1) above.

In formula (1) above, X₁ and X₂ independently represent a hydrogen atom or a halogen atom, provided that at least one of X₁ and X₂ is a halogen atom; X₃ represents a halogen atom; n is an integer of from 1 to 5; R₁ represents a monovalent substituent; 1 is an integer of from 0 to 3; R₂ represents a monovalent substituent; and m is an integer of 0 or 1.

The halogen atom represented by X₁, X₂, and X₃ represents a chlorine atom, a bromine atom or an iodine atom, and preferably a chlorine atom.

The monovalent substituent of R₁ or R₂ may be any substituent as long as it is an organic group which can be a substituent on the benzene ring. Examples thereof include, an alkyl group (for example, a methyl group, an ethyl group, a propyl group, an isopropyl group, a t-butyl group, a pentyl group, a hexyl group, an octyl group, a dodecyl group, a tridecyl group, a tetradecyl group, or a pentadecyl group), a cycloalkyl group (for example, a cyclopentyl group or a cyclohexyl group), an alkenyl group (for example, a vinyl group or a allyl group), an alkinyl group (for example, a propargyl group), an aryl group (for example, a phenyl group, or a naphthyl group), a heterocyclic group (for example, a pyrrolidinyl group, an imidazolidinyl group, a morpholinyl group or an oxazolidinyl group), an alkoxy group (for example, a methoxy group, an ethoxy group, a propoxy group, a pentyloxy group, a hexyloxy group, an octyloxy group, or a dodecyloxy group), a cycloalkoxy group (for example, a cyclopentyloxy group, or a cyclohexyloxy group), an aryloxy group (for example, a phenoxy group or a naphthyloxy group), an alkylthio group (for example, a methylthio group, an ethylthio group, a propylthio group, a pentylthio group, a hexylthio group, an octylthio group, or a dodecylthio group), a cycloalkylthio group (for example, a cyclopentylthio group or a cyclohexylthio group), an arylthio group (for example, a phenylthio group, or a naphthylthio group), an alkoxycarbonyl group (for example, a methyloxycarbonyl group, an ethyloxycarbonyl group, a butyloxycarbonyl group, an octyloxycarbonyl group, or a dodecyloxycarbonyl group), an aryloxycarbonyl group (for example, a phenyloxycarbonyl group, or a naphthyloxycarbonyl group), a sulfamoyl group (for example, an aminosulfonyl group, a methylaminosulfonyl group, a dimethylaminosulfonyl group, a butylaminosulfonyl group, a hexylaminosulfonyl group, a cyclohexylaminosulfonyl group, an octylaminosulfonyl group, a dodecylaminosulfonyl group, a phenylaminosulfonyl group, a naphthylaminosulfonyl group, or a 2-pyridylaminosulfonyl group), an acyl group (for example, an acetyl group, an ethylcarbonyl group, a propylcarbonyl group, a pentylcarbonyl group, a cyclohexylcarbonyl group, an octylcarbonyl group, a 2-ethylhexylcarbonyl group, a dodecycarbonyl group, a phenylcarbonyl group, a naphthylcarbonyl group, or a pyridylcarbonyl group), an amido group (for example, a methylcarbonylamino group, an ethylcarbonylamino group, a dimethylcarbonylamino group, a propylcarbonylamino group, a pentylcarbonylamino group, a cyclohexylcarbonylamino group, 2-ethylhexylcarbonylamino group, an octylcarbonylamino group, a a dodecycarbonylamino group, a phenylcarbonylamino group, or a naphthylcarbonylamino group), a carbamoyl group (for example, an aminocarbonyl group, a methylaminocarbonyl group, a dimethylaminocarbonyl group, a propylaminocarbonyl group, a pentylaminocarbonyl group, a cyclohexylaminocarbonyl group, an octylaminocarbonyl group, a 2-ethylhexylaminocarbonyl group, a dodecyaminocarbonyl group, a phenylaminocarbonyl group, a naphthylaminocarbonyl group, or a 2-pyridylaminocarbonyl group), a ureido group (for example, a methylureido group, an ethylureido group, a pentylureido group, a cyclohexylureido group, an octylureido group, a dodecylureido group, a phenylureido group, a naphthylureido group, or a 2-pyridylaminoureido group), an alkylsulfonyl group (for example, a methylsulfonyl group, an ethylsulfonyl group, a butylsulfonyl group, a cyclohexylsulfonyl group, a 2-ethylhexylsulfonyl group, or a dodecylsulfonyl group), an arylsulfonyl group (for example, a phenylsulfonyl group, a naphthylsulfonyl group, or a 2-pyridylsulfonyl group), an amino group (for example, an amino group, an ethylamino group, a dimethylamino group, a butylaminocarbonyl group, a cyclopentylamino group, a 2-ethylhexylamino group, a dodecyamino group, an anilino group, a naphthylamino group, or a 2-pyridylamino group), a cyano group, a nitro group or a hydroxyl group. These can have the same group as above as a substituent. Any adjacent two of these may combine with each other to form a ring.

Among these, an alkyl group or an alkoxy group is especially preferred.

Among compounds represented by formula (1), compounds in which R₂ is an alkyl group or an alkoxy group are preferred in view of sensitivity and safelight property, among these, compounds in which X₁ is a chlorine atom, X₂ is a hydrogen atom and X₃ is a chlorine atom are preferred, and among these, compounds in which R₂ is an alkoxy group, X₁ is a chlorine atom, X₂ is a hydrogen atom and X₃ is a chlorine atom are preferred.

Preferred examples of the represented by formula (1) will be listed below.
(I-1-1): 2,2'-Di(2-chlorophenyl)-4,4'-di(2-chlorophenyl)-5,5'-diphenyl-bisimidazole
(I-1-2): 2,2'-Di(2-bromophenyl)-4,4'-di(2-chlorophenyl)-5,5'-diphenyl-bisimidazole
(I-1-3): 2,2'-Di(2,6-dichlorophenyl)-4,4'-di(2-chlorophenyl)-5,5'-diphenyl-bisimidazole
(I-1-4): 2,2'-Di(2,6-difluorophenyl)-4,4'-di(2-chlorophenyl)-5,5'-diphenyl-bisimidazole
(I-1-5): 2,2'-Di(2-dichloro-4-tolyl)-4,4'-di(2-chlorophenyl)-5,5'-diphenyl-bisimidazole
(I-1-6): 2,2'-Di(2-dichloro-3-ethoxyphenyl)-4,4'-di(2-chlorophenyl)-5,5'-diphenyl-bisimidazole
(I-1-7): 2,2'-Di(2-chlorophenyl)-4,4'-di(2,6-dichlorophenyl)-5,5'-diphenyl-bisimidazole
(I-1-8): 2,2'-Di(2-chlorophenyl)-4,4'-di(2,5-dichlorophenyl)-5,5'-diphenyl-bisimidazole
(I-1-9): 2,2'-Di(2-chlorophenyl)-4,4'-di(3,4,5-trichlorophenyl)-5,5'-diphenyl-bisimidazole
(I-1-10): 2,2'-Di(2,6-dichlorophenyl)-4,4'-di(2,6-dichlorophenyl)-5,5'-diphenyl-bisimidazole
(I-2-1): 2,2'-Di(2-chlorophenyl)-4,4'-di(2-chlorophenyl)-5,5'-di(3-tolyl)-bisimidazole
(I-2-2): 2,2'-Di(2-bromophenyl)-4,4'-di(2-chlorophenyl)-5,5'-di(3-tolyl)-bisimidazole
(I-2-3): 2,2'-Di(2,6-dichlorophenyl)-4,4'-di(2-chlorophenyl)-5,5'-di(3-tolyl)-bisimidazole
(I-2-4): 2,2'-Di(2,6-difluorophenyl)-4,4'-di(2-chlorophenyl)-5,5'-di(2-tolyl)-bisimidazole
(I-2-5): 2,2'-Di(2-dichloro-4-tolyl)-4,4'-di(2-chlorophenyl)-5,5'-di(2-tolyl)-bisimidazole
(I-2-6): 2,2'-Di(2-dichloro-3-ethoxyphenyl)-4,4'-di(2-chlorophenyl)-5,5'-di(2-tolyl)-bisimidazole
(I-2-7): 2,2'-Di(2-chlorophenyl)-4,4'-di(2,6-dichlorophenyl)-5,5'-di(4-tolyl)-bisimidazole
(I-2-8): 2,2'-Di(2-chlorophenyl)-4,4'-di(2,5-dichlorophenyl)-5,5'-di(4-tolyl)-bisimidazole
(I-2-9): 2,2'-Di(2-chlorophenyl)-4,4'-di(3,4,5-trichlorophenyl)-5,5'-di(4-tolyl)-bisimidazole
(I-2-10): 2,2'-Di(2,6-dichlorophenyl)-4,4'-di(2,6-dichlorophenyl)-5,5'-di(4-tolyl)-bisimidazole
(I-3-1): 2,2'-Di(2-chlorophenyl)-4,4'-di(2-chlorophenyl)-5,5'-di(3-ethoxyphenyl)-bisimidazole
(1-3-2) : 2,2'-Di(2-bromophenyl)-4,4'-di(2-chlorophenyl)-5,5'-di(3-ethoxyphenyl)-bisimidazole
(I-3-3): 2,2'-Di(2,6-dichlorophenyl)-4,4'-di(2-chlorophenyl)-5,5'-di (3-ethoxyphenyl)-bisimidazole
(I-3-4): 2,2'-Di(2,6-difluorophenyl)-4,4'-di(2-chlorophenyl)-5,5'-di(2-methoxyphenyl)-bisimidazole
(I-3-5): 2,2'-Di (2-chloro-4-tolyl)-4,4'-di(2-chlorophenyl)-5,5'-di(2-methoxyphenyl)-bisimidazole
(I-3-6): 2,2'-Di(2-chloro-3-ethoxyphenyl)-4,4'-di(2-chlorophenyl)-5,5'-di(2-methoxyphenyl)-bisimidazole
(I-3-7): 2,2'-Di(2-chlorophenyl)-4,4'-di(2,6-dichlorophenyl)-5,5'-di(4-methoxyphenyl)-bisimidazole
(I-3-8): 2,2'-Di(2-chlorophenyl)-4,4'-di(2,5-dichlorophenyl)-5,5'-di(4-methoxyphenyl)-bisimidazole
(I-3-9): 2,2'-Di(2-chlorophenyl)-4,4'-di(3,4,5-trichlorophenyl)-5,5'-di(4-methoxyphenyl)-bisimidazole
(I-3-10): 2,2'-Di(2,6-dichlorophenyl)-4,4'-di(2,6-dichlorophenyl)-5,5'-di(4-methoxyphenyl)-bisimidazole

The content of the compound represented by formula (1) in the light-sensitive layer is preferably from 1.0 to 30% by weight, and more preferably from 2.0 to 20% by weight, based on the total solid content of light sensitive layer, in view of sensitivity and safelight property.

The content of this compound in the light-sensitive layer is preferably from 3.0 to 50% by weight, and more preferably from 6.7 to 33% by weight, based on the content of the polymerizable ethylenically unsaturated compound in the light sensitive layer, in view of sensitivity and safelight property.

The image formation layer in the invention may contain, as the photopolymerization initiator, such a polymerization initiator as described below in combination with a compound represented by formula (1) above.

As a preferred photopolymerization initiator contained in combination with the compound represented by formula (1), there is a titanocene compound, a monoalkyltriaryl borate compound, an iron arene complex, a polyhalogenated compound or a biimidazole compound other than the compound represented by formula (1).

As the titanocene compounds, there are those described in Japanese Patent O.P.I. Publication Nos. 63-41483 and 2-291. Preferred examples of titanocene compounds include bis(cyclopentadienyl)-Ti-di-chloride, bis(cyclopentadienyl)-Ti-bis-phenyl, bis (cyclopentadienyl)-Ti-bis-2,3,4,5,6-pentaflurophenyl, bis(cyclopentadienyl)-Ti-bis-2,3,5,6-tetrafluorophenyl, bis (cyclopentadienyl)-Ti-bis-2,4,6-trifluorophenyl, bis (cyclopentadienyl)-Ti-bis-2,6-difluorophenyl, bis(cyclopentadienyl)-Ti-bis-2,4-difluorophenyl, bis(methylcyclopentadienyl)-Ti-bis-2,3,4,5,6-pentafluorophenyl, bis (methylcyclopentadienyl)-Ti-bis-2,3,5,6-tetrafluorophenyl, bis(methylcyclopentadienyl)-Ti-bis-2,6-difluorophenyl (IRUGACURE 784, produced by Ciba Speciality Chemicals Co.), bis(cyclopentadienyl)-bis(2,4,6-trifluoro-3-(pyry-1-yl) phenyl) titanium, and bis (cyclopentadienyl)-bis(2,4,6-trifluoro-3-(2-5-dimethylpyry-1-yl)phenyl)titanium.

As the monoalkyltriaryl borate compounds, there are those described in Japanese Patent O.P.I. Publication Nos. 62-150242 and 62-143044. Preferred examples of the monoalkyltriaryl borate compounds include tetra-n-butyl ammonium n-butyl-trinaphthalene-1-yl-borate, tetra-n-butyl ammonium n-butyl-triphenyl-borate, tetra-n-butyl ammonium n-butyl-tri-(4-tert-butylphenyl)-borate, tetra-n-butyl ammonium n-hexyl-tri-(3-chloro-4-methylphenyl)-borate, and tetra-n-butyl ammonium n-hexyl-tri-(3-fluorophenyl)-borate.

As the iron-arene complexes, there are those disclosed in Japanese Patent O.P.I. Publication No. 59-219307.

Preferred examples of the iron-arene complex include η-benzene-(η-cyclopentadienyl)iron hexafluorophosphate, η-cumene-(η-cyclopentadienyl)iron hexafluorophosphate, η-fluorene-(η-cyclopentadienyl) iron hexafluorophosphate, η-naphthalene-η-cyclopentadienyl) iron hexafluorophosphate, η-xylene-η-cyclopentadienyl) iron hexafluorophosphate, and η-benzene-η-cyclopentadienyl)iron tetrafluorophosphate.

As the polyhalogenated compound is preferably used a compound having a trihalomethyl group, a dihalomethyl group or a dihalomethylene group. A halogen compound represented by the following formula (3) or a compound having in the oxadiazole ring the group described above as the substituent or is more preferably used.

Among these, a halogen compound represented by the following formula (4) is especially preferably used.

Formula (3) R¹-CY₂-(C=O)-R²

wherein R¹ represents a hydrogen atom, a halogen atom, an alkyl group, an aryl group, an acyl group, an alkylsulfonyl group, an arylsulfonyl group, an iminosulfo group or a cyano group; R² represents a monovalent substituent, provided that R¹ and R² may combine with each other to form a ring; and Y represents a halogen atom.

Formula (4) CY₃- (C=O)-X-R³

wherein R³ represents a monovalent substituent; X represents -O- or -NR⁴- in which R⁴ represents a hydrogen atom or an alkyl group, provided that R³ and R⁴ may combine with each other to form a ring; and Y represents a halogen atom.

Among these, those having a polyhaloacetylamido group are preferably used.

A compound having in the oxadiazole ring a polyhalomethyl group as the substituent is preferably used. An oxadiazole compound disclosed in Japanese Patent O.P.I. Publication Nos. 5-34904 and 8-240909 also is preferably used.

Examples of the biimidazole compound other than the compound represented by formula (1) above include those disclosed in for example, Japanese Patent O.P.I. Publication No. 2003-295426.

As the biimidazole compound other than the compound represented by formula (1) above, a hexaarylbisimidazole (HABI, a dimer of a triarylimidazole) compound can be preferably used.

The synthetic method of the hexaarylbisimidazoles (HABI, dimmers of triarylimidazoles) is disclosed in DE 1470154, and use thereof in a photopolymerizable composition is disclosed in EP 24629, EP 107792, US 4410621, EP 215453 and DE 321312.

Preferred examples of the derivatives include 2,4,5,2',4',5'-hexaphenylbisimidazole, 2,2'-bis (2-chlorophenyl)-4,5,4',5'-tetraphenylbisimidazole, 2,2'-bis (2-bromophenyl)-4,5,4',5'-tetraphenylbisimidazole, 2,2'-bis(2,4-dichlorophenyl)-4,5,4',5'-tetraphenylbisimidazole, 2,2'-bis(2-chlorophenyl)-4,5,4',5'-tetrakis(3-methoxyphenyl)bisimidazole, 2,2'-bis(2-chlorophenyl)-4,5,4',5'-tetrakis(3,4,5-trimethoxyphenyl)bisimidazole, 2,5,2',5'-tetrakis(2-chlorophenyl)-4,4'-bis(3,4-dimethoxyphenyl)bisimidazole, 2,2'-bis(2,6-dichlorophenyl)-4,5,4',5'-tetraphenylbisimidazole, 2,2'-bis(2-nitrophenyl)-4,5,4',5'-tetraphenylbisimidazole, 2,2'-di-o-tolyl-4,5,4',5'-tetraphenylbisimidazole, 2,2'-bis(2-ethoxyphenyl)-4,5,4',5'-tetraphenylbisimidazole, and 2,2'-bis(2,6-difluorophenyl)-4,5,4',5'-tetraphenylbisimidazole.

As the photopolymerization initiator used in combination, there are compounds described below.

A benzoin derivative such as benzoin methyl ether, benzoin i-propyl ether, or α,α-dimethoxy-α-phenylacetophenone; a benzophenone derivative such as benzophenone, 2,4-dichlorobenzophenone, o-benzoyl methyl benzoate, or 4,4'-bis (dimethylamino) benzophenone; a thioxanthone derivative such as 2-chlorothioxanthone, 2-i-propylthioxanthone; an anthraquinone derivative such as 2-chloroanthraquinone or 2-methylanthraquinone; an acridone derivative such as N-methylacridone or N-butylacridone; α,α-diethoxyacetophenone; benzil; fluorenone; xanthone; an uranyl compound; a triazine derivative disclosed in Japanese Patent Publication Nos. 59-1281 and 61-9621 and Japanese Patent O.P.I. Publication No. 60-60104; an organic peroxide compound disclosed in Japanese Patent O.P.I. Publication Nos. 59-1504 and 61-243807; a diazonium compound in Japanese Patent Publication Nos. 43-23684, 44-6413, 47-1604 and US Patent No. 3,567,453; an organic azide compound disclosed in US Patent Nos. 2,848,328, 2,852,379 and 2,940,853; orthoquinondiazide compounds disclosed in Japanese Patent Publication Nos. 36-22062b, 37-13109, 38-18015 and 45-9610; various onium compounds disclosed in Japanese Patent Publication No. 55-39162, Japanese Patent O.P.I. Publication No. 59-14023 and "Macromolecules", Volume 10, p. 1307 (1977); azo compounds disclosed in Japanese Patent Publication No. 59-142205; metal arene complexes disclosed in Japanese Patent O.P.I. Publication No. 1-54440, European Patent Nos. 109,851 and 126,712, and "Journal of Imaging Science", Volume 30, p. 174 (1986); (oxo) sulfonium organoboron complexes disclosed in Japanese Patent O.P.I. Publication Nos. 5-213861 and 5-255347; titanocenes disclosed in Japanese Patent O.P.I. Publication Nos. 59-152396 and 61-151197; transition metal complexes containing a transition metal such as ruthenium disclosed in "Coordination Chemistry Review", Volume 84, p. 85-277 (1988) and Japanese Patent O.P.I. Publication No. 2-182701; 2,4,5-triarylimidazol dimmer disclosed in Japanese Patent O.P.I. Publication No. 3-209477; carbon tetrabromide; organic halide compounds disclosed in Japanese Patent O.P.I. Publication No. 59-107344.

The content of the polymerization initiator (total content of the polymerization initiator used) in the light-sensitive layer is preferably from 0.1 to 20% by weight, and more preferably from 0.5 to 15% by weight, based on the weight of polymerizable ethylenically unsaturated compound used.

### Polymerizable Ethylenically Unsaturated Compound (B)

The polymerizable ethylenically unsaturated compound (B) in the invention is a compound having an ethylenic double bond capable of undergoing polymerization due to a photopolymerization initiator contained in the image formation layer imagewise exposed.

As the ethylenically unsaturated compound, there are a known monomer such as a conventional radically polymerizable monomer and a polyfunctional monomer or oligomer having two or more of an ethylenic double bond in the molecule generally used in a conventional ultraviolet curable resin composition. The monomers are not specifically limited. Typical examples thereof include a monofunctional acrylate such as 2-ethylhexyl acrylate, 2-hydroxypropyl acrylate, glycerol acrylate, tetrahydrofurfuryl acrylate, phenoxyethyl acrylate, nonylphenoxyethyl acrylate, tetrahydrofurfuryl-oxyethyl acrylate, tetrahydrofurfuryloxyhexanorideacrylate, an ester of 1,3-dioxane-ε-caprolactone adduct with acrylic acid, or 1,3-dioxolane acrylate; a methacrylate, itaconate, crotonate or maleate alternative of the above acrylate; a bifunctional acrylate such as ethyleneglycol diacrylate, triethyleneglycol diacrylate, pentaerythritol diacrylate, hydroquinone diacrylate, resorcin diacrylate, hexanediol diacrylate, neopentyl glycol diacrylate, tripropylene glycol diacrylate, hydroxypivalic acid neopentyl glycol diacrylate, neopentyl glycol adipate diacrylate, diacrylate of hydroxypivalic acid neopentyl glycol-ε-caprolactone adduct, 2-(2-hydroxy-1,1-dimethylethyl)-5-hydroxymethyl-5-ethyl-1,3-dioxane diacrylate, tricyclodecanedimethylol acrylate, tricyclodecanedimethylol acrylate-ε-caprolactone adduct or 1,6-hexanediol diglycidylether diacrylate; a dimethacrylate, diitaconate, dicrotonate or dimaleate alternative of the above diacrylate; a polyfunctional acrylate such as trimethylolpropane triacrylate, ditrimethylolpropane tetraacrylate, trimethylolethane triacrylate, pentaerythritol triacrylate, pentaerythritol tetraacrylate, dipentaerythritol tetraacrylate, dipentaerythritol pentaacrylate, dipentaerythritol hexacrylate, dipentaerythritol hexacrylate-ε-caprolactone adduct, pyrrogallol triacrylate, propionic acid dipentaerythritol triacrylate, propionic acid dipentaerythritol tetraacrylate or hydroxypivalylaldehyde modified dimethylolpropane triacrylate; a methacrylate, itaconate, crotonate or maleate alternative of the above polyfunctional acrylate.

A prepolymer can be used, and examples of the prepolymer include compounds as described later. The prepolymer with a photopolymerizable property, which is obtained by incorporating acrylic acid or methacrylic in an oligomer with an appropriate molecular weight, can be suitably employed. These prepolymers can be used singly, in combination or as their mixture with the above described monomers and/or oligomers.

Examples of the prepolymer include polyester (meth)acrylate obtained by incorporating (meth)acrylic acid in a polyester of a polybasic acid such as adipic acid, trimellitic acid, maleic acid, phthalic acid, terephthalic acid, hymic acid, malonic acid, succinic acid, glutaric acid, itaconic acid, pyromellitic acid, fumalic acid, pimelic acid, sebatic acid, dodecanic acid or tetrahydrophthalic acid with a polyol such as ethylene glycol, ethylene glycol, diethylene glycol, propylene oxide, 1,4-butane diol, triethylene glycol, tetraethylene glycol, polyethylene glycol, grycerin, trimethylol propane, pentaerythritol, sorbitol, 1,6-hexanediol or 1,2,6-hexanetriol; an epoxyacrylate such as bisphenol A·epichlorhydrin·(meth)acrylic acid or phenol novolak·epichlorhydrin·(meth)acrylic acid obtained by incorporating (meth)acrylic acid in an epoxy resin; an urethaneacrylate such as ethylene glycol·adipic acid·tolylenediisocyanate·2-hydroxyethylacrylate, polyethylene glycol·tolylenediisocyanate·2-hydroxyethylacrylate, hydroxyethylphthalyl methacrylate·xylenediisocyanate, 1,2-polybutadieneglycol·tolylenediisocyanate·2-hydroxyethylacrylate or trimethylolpropane-propylene glycol·tolylenediisocyanate·2-hydroxyethylacrylate, obtained by incorporating (meth)acrylic acid in an urethane resin; a silicone acrylate such as polysiloxane acrylate, or polysiloxane·diisocyanate·2-hydroxyethylacrylate; an alkyd modified acrylate obtained by incorporating a methacroyl group in an oil modified alkyd resin; and a spiran resin acrylate.

The light sensitive layer in the invention may contain a monomer such as a phosphazene monomer, triethylene glycol, an EO modified isocyanuric acid diacrylate, an EO modified isocyanuric acid triacrylate, dimethyloltricyclodecane diacrylate, trimethylolpropane acrylate benzoate, an alkylene glycol acrylate, or a urethane modified acrylate, or an addition polymerizable oligomer or prepolymer having a structural unit derived from the above monomer.

The ethylenic monomer used in the invention is preferably a phosphate compound having at least one (meth)acryloyl group. The phosphate compound is a compound having a (meth)acryloyl group in which at least one hydroxyl group of phosphoric acid is esterified, and the phosphate compound is not limited as long as it has a (meth)acryloyl group.

Besides the above compounds, compounds disclosed in Japanese Patent O.P.I. Publication Nos. 58-212994, 61-6649, 62-46688, 62-48589, 62-173295, 62-187092, 63-67189, and 1-244891, compounds described on pages 286 to 294 of "11290 Chemical Compounds" edited by Kagakukogyo Nipposha, and compounds described on pages 11 to 65 of "UV·EB Koka Handbook (Materials)" edited by Kobunshi Kankokai can be suitably used. Of these compounds, compounds having two or more acryl or methacryl groups in the molecule are preferable, and those having a molecular weight of not more than 10,000, and preferably not more than 5,000 are more preferable.

The image formation layer in the invention preferably contains an addition polymerizable ethylenically unsaturated compound having a tertiary amino group in the molecule, which is a tertiary amine monomer. Its molecular structure is not limited, but those are preferred in which a tertiary amine having a hydroxyl group is modified with glycidyl methacrylate, methacrylic chloride, or acrylic chloride. Examples thereof include a polymerizable compound disclosed in Japanese Patent O.P.I. Publication Nos. 1-165613, 1-203413 and 1-197213.

A reaction product of a polyhydric alcohol having a tertiary amino group in the molecule, a diisocyanate and a compound having a hydroxyl group and an addition polymerizable ethylenically double bond in the molecule is preferably used in the invention.

Examples of the polyhydric alcohol having a tertiary amino group in the molecule include triethanolamine, N-methyldiethanolamine, N-ethyldiethanolamine, N-ethyldiethanolamine, N-n-butyldiethanolamine, N-tert-butyldiethanolamine, N,N-di(hydroxyethyl)aniline, N,N, N', N'-tetra-2-hydroxypropylethylenediamine, p-tolyldiethanolamine, N,N, N', N'-tetra-2-hydroxyethylethylenediamine, N,N-bis (2-hydroxypropyl) aniline, allyldiethanolamine, 3-dimethylamino-1,2-propane diol, 3-diethylamino-1,2-propane diol, N,N-di(n-propylamino)-2,3-propane diol, N,N-di(iso-propylamino)-2,3-propane diol, and 3-(N-methyl-N-benzylamino)-1,2-propane diol, but the invention is not specifically limited thereto.

Examples of the diisocyanate include butane-1,4-diisocyanate, hexane-1,6-diisocyanate, 2-methylpentane-1,5-diisocyanate, octane-1,8-diisocyanate, 1,3-diisocyanatomethylcyclohexanone, 2,2,4-trimethylhexane-1,6-diisocyanate, isophorone diisocyanate, 1,2-phenylene diisocyanate, 1,3-phenylene diisocyanate, 1,4-phenylene diisocyanate, tolylene-2,4-diisocyanate, tolylene-2,5-diisocyanate, tolylene-2,6-diisocyanate, 1,3-di(isocyanatomethyl)benzene, and 1,3-bis(1-isocyanato-1-methylethyl)benzene, but the invention is not specifically limited thereto.

Examples of the compound having a hydroxyl group and an addition polymerizable ethylenically double bond in the molecule include include 2-hydroxyethyl methacrylate (MH-1), 2-hydroxyethyl acrylate (MH-2), 4-hydroxybutyl acrylate (MH-4), 2-hydroxypropylene-1,3-dimethacrylate (MH-7), and 2-hydroxypropylene-1-methacrylate-3-acrylate (MH-8).

The reaction product above can be synthesized according to the same method as a conventional method in which a urethaneacrylate compound is ordinarily synthesized employing an ordinary diol, a diisocyanate and an acrylate having a hydroxyl group.

Examples of the reaction product of a polyhydric alcohol having a tertiary amino group in the molecule, a diisocyanate and a compound having a hydroxyl group and an addition polymerizable ethylenically double bond in the molecule will be listed below.
M-1: A reaction product of triethanolamine (1 mole), hexane-1,6-diisocyanate (3 moles), and 2-hydroxyethyl methacrylate (3 moles)
M-2: A reaction product of triethanolamine (1 mole), isophorone diisocyanate (3 moles), and 2-hydroxyethyl methacrylate (3 moles)
M-3: A reaction product of N-n-butyldiethanolamine (1 mole), 1,3-bis(1-cyanato-1-methylethyl)benzene (2 moles), and 2-hydroxypropylene-1-methacrylate-3-acrylate (2 moles)
M-4: A reaction product of N-n-butyldiethanolamine (1 mole), 1,3-di(cyanatomethyl)benzene (2 moles), and 2-hydroxypropylene-1-methacrylate-3-acrylate (2 moles)
M-5: A reaction product of N-methydiethanolamine (1 mole), tolylene-2,4-diisocyanate (2 moles), and 2-hydroxypropylene-1,3-dimethacrylate (2 moles)

In addition to the above, acrylates or methacrylates disclosed in Japanese Patent O.P.I. Publication Nos. 1-105238 and 2-127404 can be used.

### Dye (C) having absorption maximum in the wavelength regions of from 350 to 450 nm

As the dye in the invention having absorption maximum in the wavelength regions of from 350 to 450 nm, there is a dye described later. Particularly the dye represented by formula (2) above provides the preferred results in sensitivity and safelight property.

In formula (2), R¹ through R⁶ independently represent a hydrogen atom, an alkyl group (for example, a methyl group, an ethyl group, a propyl group, an isopropyl group, a t-butyl group, a pentyl group, a hexyl group, an octyl group, a dodecyl group, a tridecyl group, a tetradecyl group, or a pentadecyl group), a cycloalkyl group (for example, a cyclopentyl group or a cyclohexyl group), an alkenyl group (for example, a vinyl group or a allyl group), an alkinyl group (for example, a propargyl group), an aryl group (for example, a phenyl group, or a naphthyl group), a heterocyclic group (for example, a pyrrolidinyl group, an imidazolidinyl group, a morpholinyl group or an oxazolidinyl group), an alkoxy group (for example, a methoxy group, an ethoxy group, a propoxy group, a pentyloxy group, a hexyloxy group, an octyloxy group, or a dodecyloxy group), a cycloalkoxy group (for example, a cyclopentyloxy group, or a cyclohexyloxy group), an aryloxy group (for example, a phenoxy group or a naphthyloxy group), an alkylthio group (for example, a methylthio group, an ethylthio group, a propylthio group, a pentylthio group, a hexylthio group, an octylthio group, or a dodecylthio group), a cycloalkylthio group (for example, a cyclopentylthio group or a cyclohexylthio group), an arylthio group (for example, a phenylthio group, or a naphthylthio group), an alkoxycarbonyl group (for example, a methyloxycarbonyl group, an ethyloxycarbonyl group, a butyloxycarbonyl group, an octyloxycarbonyl group, or a dodecyloxycarbonyl group), an aryloxycarbonyl group (for example, a phenyloxycarbonyl group, or a naphthyloxycarbonyl group), a sulfamoyl group (for example, an aminosulfonyl group, a methylaminosulfonyl group, a dimethylaminosulfonyl group, a butylaminosulfonyl group, a hexylaminosulfonyl group, a cyclohexylaminosulfonyl group, an octylaminosulfonyl group, a dodecylaminosulfonyl group, a phenylaminosulfonyl group, a naphthylaminosulfonyl group, or a 2-pyridylaminosulfonyl group), an acyl group (for example, an acetyl group, an ethylcarbonyl group, a propylcarbonyl group, a pentylcarbonyl group, a cyclohexylcarbonyl group, an octylcarbonyl group, a 2-ethylhexylcarbonyl group, a dodecycarbonyl group, a phenylcarbonyl group, a naphthylcarbonyl group, or a pyridylcarbonyl group), an amido group (for example, a methylcarbonylamino group, an ethylcarbonylamino group, a dimethylcarbonylamino group, a propylcarbonylamino group, a pentylcarbonylamino group, a cyclohexylcarbonylamino group, 2-ethylhexylcarbonylamino group, an octylcarbonylamino group, a a dodecycarbonylamino group, a phenylcarbonylamino group, or a naphthylcarbonylamino group), a carbamoyl group (for example, an aminocarbonyl group, a methylaminocarbonyl group, a dimethylaminocarbonyl group, a propylaminocarbonyl group, a pentylaminocarbonyl group, a cyclohexylaminocarbonyl group, an octylaminocarbonyl group, a 2-ethylhexylaminocarbonyl group, a dodecyaminocarbonyl group, a phenylaminocarbonyl group, a naphthylaminocarbonyl group, or a 2-pyridylaminocarbonyl group), a ureido group (for example, a methylureido group, an ethylureido group, a pentylureido group, a cyclohexylureido group, an octylureido group, a dodecylureido group, a phenylureido group, a naphthylureido group, or a 2-pyridylaminoureido group), an alkylsulfonyl group (for example, a methylsulfonyl group, an ethylsulfonyl group, a butylsulfonyl group, a cyclohexylsulfonyl group, a 2-ethylhexylsulfonyl group, or a dodecylsulfonyl group), an arylsulfonyl group (for example, a phenylsulfonyl group, a naphthylsulfonyl group, or a 2-pyridylsulfonyl group), an amino group (for example, an amino group, an ethylamino group, a dimethylamino group, a butylaminocarbonyl group, a cyclopentylamino group, a 2-ethylhexylamino group, a dodecyamino group, an anilino group, a naphthylamino group, or a 2-pyridylamino group), a halogen atom (for example, fluorine, chlorine, or bromine), a cyano group, a nitro group, or a hydroxyl group. These can have the same group as above as a substituent. Any adjacent two of these may combine with each other to form a ring.

Those compounds are more preferred in which in formula (2), R⁵ is an amino group or a substituted amino group such as an alkylamino group, a dialkylamino group, an arylamino group, a diarylamino group, or an alkylarylamino group. The coumarin compounds are preferably used in which the alkyl substituent of the substituted amino group in R⁵ combines with R⁴ or R⁶ to form a ring.

Further, any one of R¹ and R² or both of R¹ and R² are preferably an alkyl group (for example, a methyl group, an ethyl group, a propyl group, an isopropyl group, a t-butyl group, a pentyl group, a hexyl group, an octyl group, a dodecyl group, a tridecyl group, a tetradecyl group, or a pentadecyl group), a cycloalkyl group (for example, a cyclopentyl group or a cyclohexyl group), an alkenyl group (for example, a vinyl group or an allyl group), an aryl group (for example, a phenyl group, or a naphthyl group), a heterocyclic group (for example, a pyrrolidinyl group, an imidazolidinyl group, a morpholinyl group or an oxazolidinyl group), an alkoxycarbonyl group (for example, a methyloxycarbonyl group, an ethyloxycarbonyl group, a butyloxycarbonyl group, an octyloxycarbonyl group, or a dodecyloxycarbonyl group), an aryloxycarbonyl group (for example, a phenyloxycarbonyl group, or a naphthyloxycarbonyl group), an acyl group (for example, an acetyl group, an ethylcarbonyl group, a propylcarbonyl group, a pentylcarbonyl group, a cyclohexylcarbonyl group, an octylcarbonyl group, a 2-ethylhexylcarbonyl group, a dodecycarbonyl group, a phenylcarbonyl group, a naphthylcarbonyl group, or a pyridylcarbonyl group), a carbamoyl group (for example, an aminocarbonyl group, a methylaminocarbonyl group, a dimethylaminocarbonyl group, a propylaminocarbonyl group, a pentylaminocarbonyl group, a cyclohexylaminocarbonyl group, an octylaminocarbonyl group, a 2-ethylhexylaminocarbonyl group, a dodecyaminocarbonyl group, a phenylaminocarbonyl group, a naphthylaminocarbonyl group, or a 2-pyridylaminocarbonyl group), a 2-ethylhexylsulfinyl group, a dodecylsulfinyl group, a phenylsulfinyl group, a naphthylsulfinyl group or a 2-pyridylsulfinyl group, an alkylsulfonyl group (for example, a methylsulfonyl group, an ethylsulfonyl group, a butylsulfonyl group, a cyclohexylsulfonyl group, a 2-ethylhexylsulfonyl group, or a dodecylsulfonyl group), an arylsulfonyl group (for example, a phenylsulfonyl group, a naphthylsulfonyl group, or a 2-pyridylsulfonyl group), a halogen atom (for example, fluorine, chlorine, or bromine), a cyano group, a nitro group, or a halogenated alkyl group (for example, a trifluoromethyl group, a tribromomethyl group, or a trichloromethyl group).

Most preferred are dyes in which in formula (2), R⁵ is an amino group (such as an unsubstituted amino group, an alkylamino group, a dialkylamino group, an arylamino group, a diarylamino group, or an alkylarylamino group); and R¹ is an alkoxycarbonyl group or a pyridyl group.

Preferred examples will be listed below, but the invention is not limited thereto.

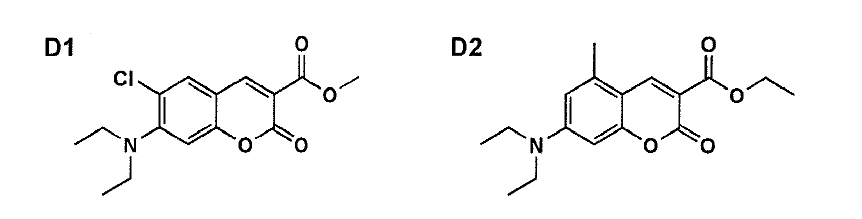

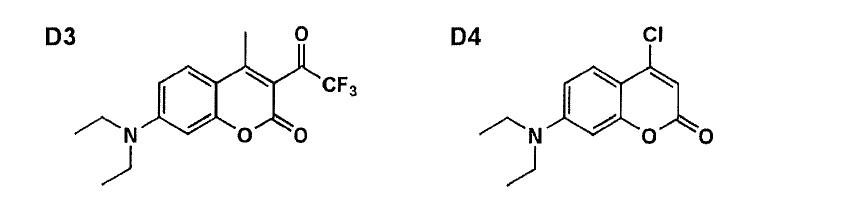

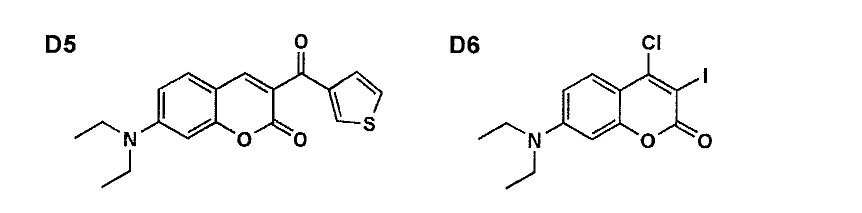

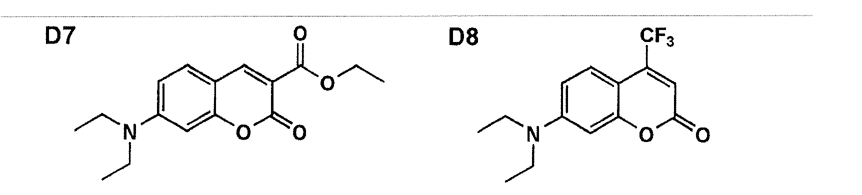

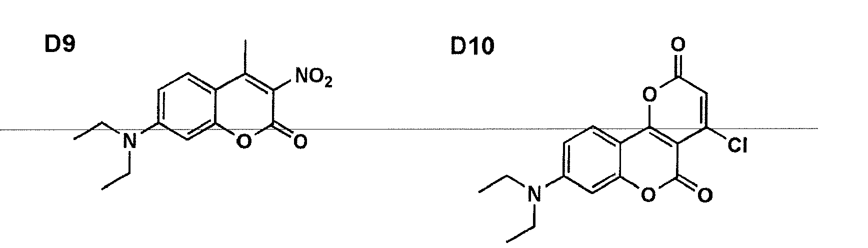

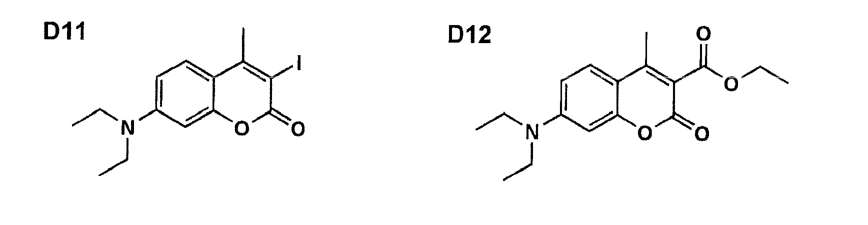

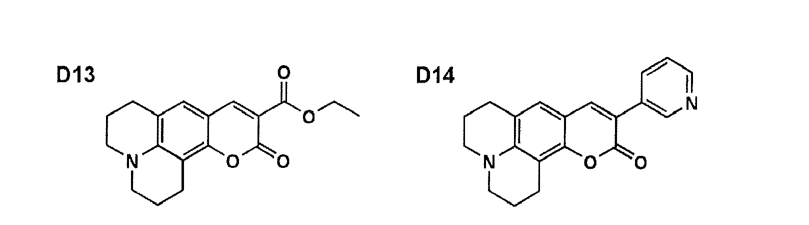

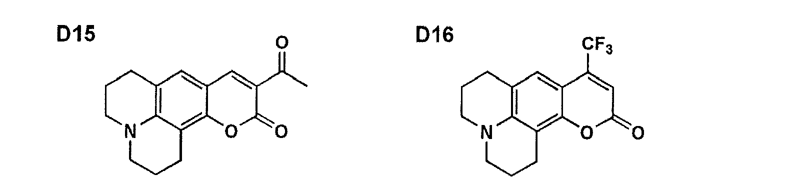

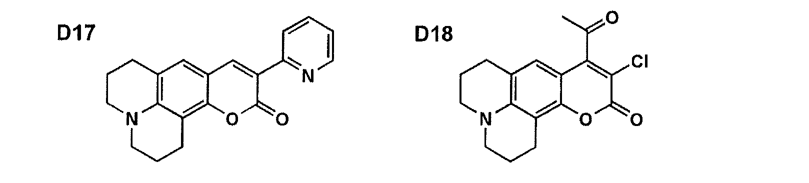

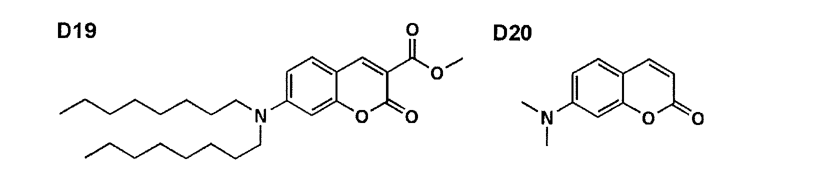

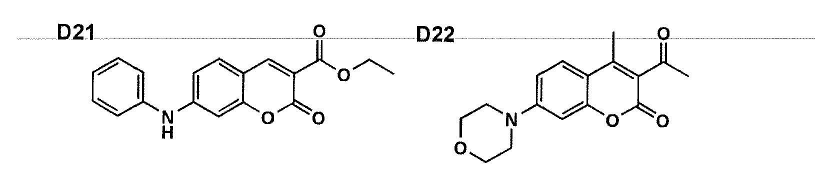

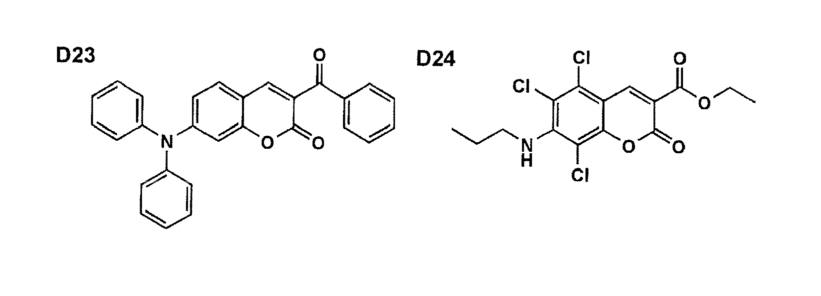

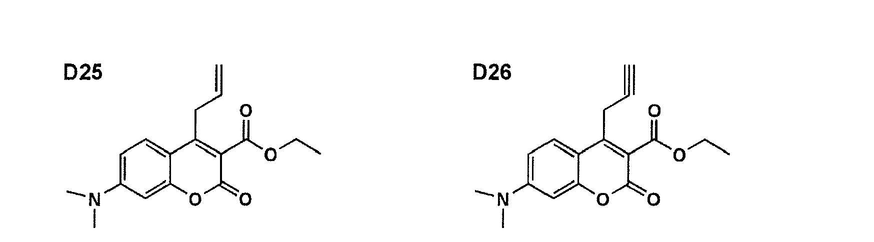

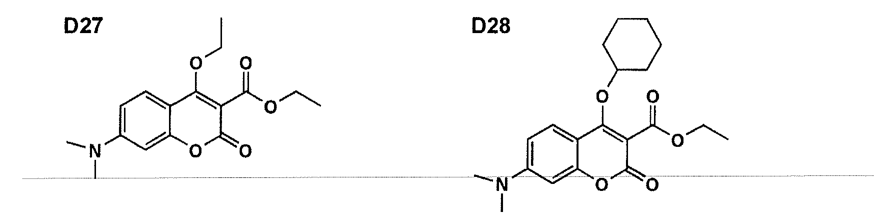

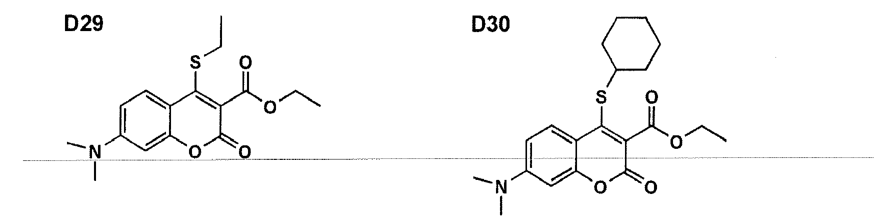

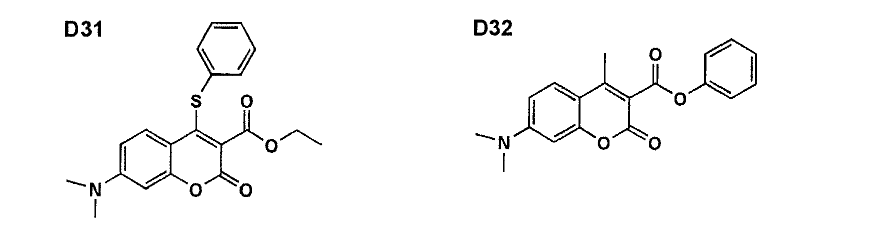

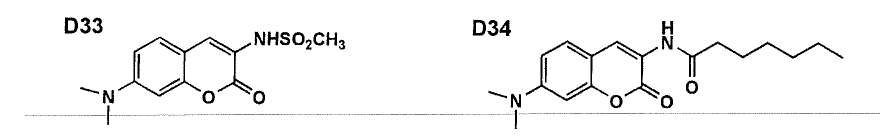

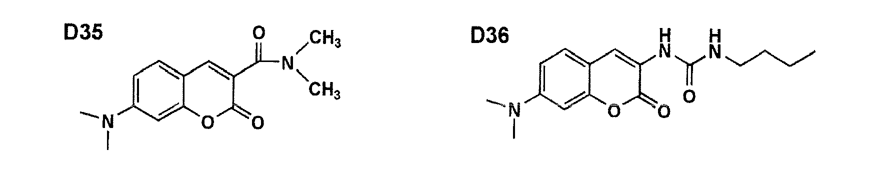

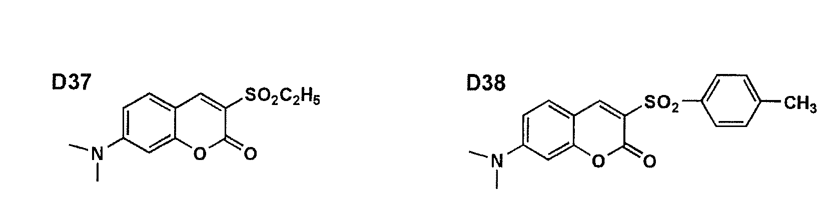

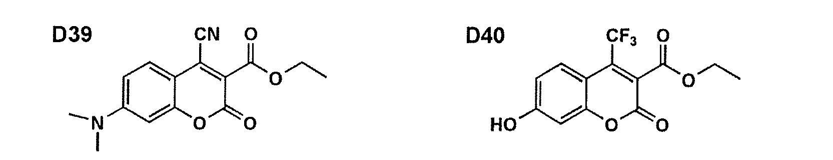

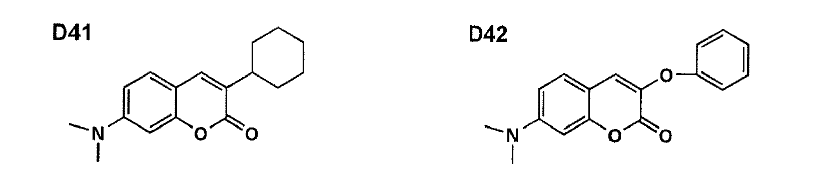

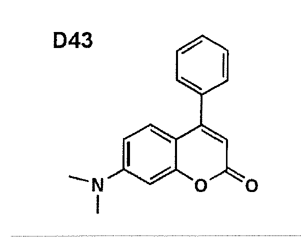

The content in the light-sensitive layer of the dye represented by formula (2) is preferably from 50 to 300% by weight, and more preferably from 70 to 250% by weight, based on the weight content of photopolymerization initiator.

Besides the dyes described above, there are coumarin derivatives B-1 through B-22 disclosed in Japanese Patent O.P.I. Publication No. 8-129258, coumarin derivatives D-1 through D-32 disclosed in Japanese Patent O.P.I. Publication No. 2003-12901, coumarin derivatives 1 through 21 disclosed in Japanese Patent O.P.I. Publication No. 2002-363206, coumarin derivatives 1 through 40 disclosed in Japanese Patent O.P.I. Publication No. 2002-363207, coumarin derivatives 1 through 34 disclosed in Japanese Patent O.P.I. Publication No. 2002-363208, coumarin derivatives 1 through 56 disclosed in Japanese Patent O.P.I. Publication No. 2002-363209, and sensitizing dyes disclosed in Japanese Patent O.P.I. Publication Nos. 2000-98605, 2000-147763, 2000-206690, 2000-258910, 2000-309724, 2001-042524, 2002-202598, and 2000-221790.

The light sensitive layer may contain other dyes than the above-described dyes as a sensitizing dye.

### Polymeric Binder (D)

The polymeric binder in the invention is one capable of carrying components contained in the image formation layer on a support. As examples thereof, there is a polyacrylate resin, a polyvinylbutyral resin, a polyurethane resin, a polyamide resin, a polyester resin, an epoxy resin, a phenol resin, a polycarbonate resin, a polyvinyl butyral resin, a polyvinyl formal resin, a shellac resin or another natural resin. These resins can be used as an admixture of two or more thereof.

The polymeric binder used in the invention is preferably a vinyl copolymer obtained by copolymerization of an acryl monomer, and more preferably a copolymer containing (a) a carboxyl group-containing monomer unit and (b) an alkyl methacrylate or alkyl acrylate unit as the copolymerization component.

Examples of the carboxyl group-containing monomer include an α,β-unsaturated carboxylic acid, for example, acrylic acid, methacrylic acid, maleic acid, maleic anhydride, itaconic acid, itaconic anhydride or a carboxylic acid such as a half ester of phthalic acid with 2-hydroxymethacrylic acid.

Examples of the alkyl methacrylate or alkyl acrylate include an unsubstituted alkyl ester such as methylmethacrylate, ethylmethacrylate, propylmethacrylate, butylmethacrylate, amylmethacrylate, hexylmethacrylate, heptylmethacrylate, octylmethacrylate, nonylmethacrylate, decylmethacrylate, undecylmethacrylate, dodecylmethacrylate, methylacrylate, ethylacrylate, propylacrylate, butylacrylate, amylacrylate, hexylacrylate, heptylacrylate, octylacrylate, nonylacrylate, decylacrylate, undecylacrylate, or dodecylacrylate; a cyclic alkyl ester such as cyclohexyl methacrylate or cyclohexyl acrylate; and a substituted alkyl ester such as benzyl methacrylate, 2-chloroethyl methacrylate, N,N-dimethylaminoethyl methacrylate, glycidyl methacrylate, benzyl acrylate, 2-chloroethyl acrylate, N,N-dimethylaminoethyl acrylate or glycidyl acrylate.

The polymeric binder in the invention can further contain, as another monomer unit, a monomer unit derived from the monomer described in the following items (1) through (14):
(1) A monomer having an aromatic hydroxy group, for example, o-, (p- or m-) hydroxystyrene, or o-, (p- or m-) hydroxyphenylacrylate;
(2) A monomer having an aliphatic hydroxy group, for example, 2-hydroxyethyl acrylate, 2-hydroxyethyl methacrylate, N-methylolacrylamide, N-methylolmethacrylamide, 4-hydroxybutyl acrylate, 4-hydroxybutyl methacrylate, 5-hydroxypentyl acrylate, 5-hydroxypentyl methacrylate, 6-hydroxyhexyl acrylate, 6-hydroxyhexyl methacrylate, N-(2-hydroxyethyl)acrylamide, N-(2-hydroxyethyl)methacrylamide, or hydroxyethyl vinyl ether;
(3) A monomer having an aminosulfonyl group, for example, m- or p-aminosulfonylphenyl methacrylate, m- or p-aminosulfonylphenyl acrylate, N-(p-aminosulfonylphenyl) methacrylamide, or N-(p-aminosulfonylphenyl)acrylamide;
(4) A monomer having a sulfonamido group, for example, N-(p-toluenesulfonyl)acrylamide, or N-(p-toluenesulfonyl)-methacrylamide;
(5) An acrylamide or methacrylamide, for example, acrylamide, methacrylamide, N-ethylacrylamide, N-hexylacrylamide, N-cyclohexylacrylamide, N-phenylacrylamide, N-nitrophenylacrylamide, N-ethyl-N-phenylacrylamide, N-4-hydroxyphenylacrylamide, or N-4-hydroxyphenylmethacrylamide;
(6) A monomer having a fluorinated alkyl group, for example, trifluoromethyl acrylate, trifluoromethyl methacrylate, tetrafluoropropyl methacrylate, hexafluoropropyl methacrylate, octafluoropentyl acrylate, octafluoropentyl methacrylate, heptadecafluorodecyl methacrylate, heptadecafluorodecyl methacrylate, or N-butyl-N-(2-acryloxyethyl)heptadecafluorooctylsulfonamide;
(7) A vinyl ether, for example, ethyl vinyl ether, 2-chloroethyl vinyl ether, propyl vinyl ether, butyl vinyl ether, octyl vinyl ether, or phenyl vinyl ether;
(8) A vinyl ester, for example, vinyl acetate, vinyl chroloacetate, vinyl butyrate, or vinyl benzoate;
(9) A styrene, for example, styrene, methylstyrene, or chloromethystyrene;
(10) A vinyl ketone, for example, methyl vinyl ketone, ethyl vinyl ketone, propyl vinyl ketone, or phenyl vinyl ketone;
(11) An olefin, for example, ethylene, propylene, isobutylene, butadiene, or isoprene;
(12) N-vinylpyrrolidone, N-vinylcarbazole, or N-vinylpyridine,
(13) A monomer having a cyano group, for example, acrylonitrile, methacrylonitrile, 2-pentenenitrile, 2-methyl-3-butene nitrile, 2-cyanoethyl acrylate, or o-, m- or p-cyanostyrene;
(14) A monomer having an amino group, for example, N,N-diethylaminoethyl methacrylate, N,N-dimethylaminoethyl acrylate, N,N-dimethylaminoethyl methacrylate, polybutadiene urethane acrylate, N,N-dimethylaminopropyl acrylamide, N,N-dimethylacrylamide, acryloylmorpholine, N-isopropylacrylamide, or N,N-diethylacrylamide.

Further another monomer may be copolymerized with the above monomer.

The polymeric binder is preferred which has, in the side chain of the molecule, both carboxyl group and polymerizable double bond. For example, an unsaturated bond-containing copolymer is preferred which is obtained by reacting a carboxyl group contained in the above vinyl copolymer molecule with for example, a compound having a (meth)acryloyl group and an epoxy group.

Examples of the compound having a double bond and an epoxy group in the molecule include glycidyl acrylate, glycidyl methacrylate and an epoxy group-containing unsaturated compound disclosed in Japanese Patent O.P.I. Publication No. 11-27196. Further, an unsaturated bond-containing copolymer which is obtained by reacting a hydroxyl group contained in the above vinyl copolymer molecule with for example, a compound having a (meth)acryloyl group and an isocyanate group. Examples of the compound having a (meth)acryloyl group and an isocyanate group in the molecule include vinyl isocyanate, (meth)acryl isocyanate, 2-(meth)acroyloxyethyl isocyanate, m- or p-isopropenyl-α,α'-dimethylbenzyl isocyanate, and (meth)acryl isocyanate, or 2-(meth)acroyloxyethyl isocyanate is preferred.

The content of the polymeric binder having in the side chain of the molecule both carboxyl group and polymerizable double bond in the light sensitive layer is preferably from 50 to 100% by weight, and more preferably 100% by weight, based on the total content of the polymeric binder contained in the light sensitive layer.

The content of the polymeric binder in the light sensitive layer is preferably from 10 to 90% by weight, more preferably from 15 to 70% by weight, and still more preferably from 20 to 50% by weight, in view of sensitivity.

### (Various additives)

The light sensitive layer in the invention is preferably added with a polymerization inhibitor, in order to prevent undesired polymerization of the ethylenically unsaturated compound during the manufacture or after storage of light sensitive planographic printing plate material.

Examples of the polymerization inhibitor include hydroquinone, p-methoxyphenol, di-t-butyl-p-cresol, pyrrogallol, t-butylcatechol, benzoquinone, 4,4'-thiobis (3-methyl-6-t-butylphenol), 2,2'-methylenebis (4-methyl-6-t-butylphenol), N-nitrosophenylhydroxylamine cerous salt, and 2-t-butyl-6-(3-t-butyl-6-hydroxy-5-mrthylbenzyl)-4-methylphenyl acrylate.

The polymerization inhibitor content is preferably 0.01 to 5% by weight based on the total solid content of the light sensitive layer. Further, in order to prevent undesired polymerization induced by oxygen, behenic acid or a higher fatty acid derivative such as behenic amide may be added to the layer. After the light sensitive layer is coated layer, the coated layer may be dried so that the higher fatty acid derivative is localized at the vicinity of the surface of the light sensitive layer. The content of the higher fatty acid derivative is preferably 0.5 to 10% by weight, based on the total solid content of the light sensitive layer.

A colorant can be also used. As the colorant can be used known materials including commercially available materials. Examples of the colorant include those described in revised edition "Ganryo Binran", edited by Nippon Ganryo Gijutu Kyoukai (publishe by Seibunndou Sinkosha), or "Color Index Binran". Pigment is preferred.

Kinds of the pigment include black pigment, yellow pigment, red pigment, brown pigment, violet pigment, blue pigment, green pigment, fluorescent pigment, and metal powder pigment. Examples of the pigment include inorganic pigment (such as titanium dioxide, carbon black, graphite, zinc oxide, Prussian blue, cadmium sulfide, iron oxide, or chromate of lead, zinc, barium or calcium); and organic pigment (such as azo pigment, thioindigo pigment, anthraquinone pigment, anthanthrone pigment, triphenedioxazine pigment, vat dye pigment, phthalocyanine pigment or its derivative, or quinacridone pigment).

Among these pigment, pigment is preferably used which does not substantially have absorption in the absorption wavelength regions of a spectral sensitizing dye used according to a laser for exposure. The absorption of the pigment used is not more than 0.05, obtained from the reflection spectrum of the pigment measured employing an integrating sphere and employing light with the wavelength of the laser used. The pigment content is preferably 0.1 to 10% by weight, and more preferably 0.2 to 5% by weight, based on the total solid content of the photopolymerizable light sensitive layer composition.

A purple pigment or a blue pigment is preferably utilized in view of absorption of light with the aforesaid photosensitive wavelength region and image visibility after development. Such pigments include, for example, Cobalt Blue, cerulean blue, Alkali Blue, Phonatone Blue 6G, Victoria Blue Lake, metal-free Phthalocyanine Blue, Phthalocyanine Fast Sky Blue, Indathrene Blue, indigo, Dioxane Violet, Isoviolanthrone Violet, Indanthrone Blue and Indanthrone BC. Among them, more preferable are Phthalocyanine Blue and Dioxane Violet.

The light sensitive layer can contain surfactants as a coating improving agent as long as the performance of the invention is not jeopardized. Among these surfactants, a fluorine-contained surfactant is preferred.

Further, in order to improve physical properties of the cured light sensitive layer, the layer can contain an inorganic filler or a plasticizer such as dioctyl phthalate, dimethyl phthalate or tricresyl phosphate. The content of such a material is preferably not more than 10% by weight, based on the total solid content of the light sensitive layer.

The solvents used in the preparation of the coating solution for the light sensitive layer in the invention include an alcohol such as sec-butanol, isobutanol, n-hexanol, or benzyl alcohol; a polyhydric alcohol such as diethylene glycol, triethylene glycol, tetraethylene glycol, or 1,5-pentanediol; an ether such as propylene glycol monobutyl ether, dipropylene glycol monomethyl ether, or tripropylene glycol monomethyl ether; a ketone or aldehyde such as diacetone alcohol, cyclohexanone, or methyl cyclohexanone; and an ester such as ethyl lactate, butyl lactate, diethyl oxalate, or methyl benzoate.

In the above, explanation of a light sensitive layer coating solution was made. The light sensitive layer in the invention is formed on a support by coating on the support the light sensitive layer coating solution.

The coating amount of the light sensitive layer is preferably from 0.1 to 10 g/m², and more preferably from 0.5 to 5 g/m².

### Protective layer (Oxygen shielding layer)

In the invention, a protective layer is preferably provided on the light sensitive layer.

It is preferred that the protective layer (oxygen shielding layer) is highly soluble in the developer as described later (generally an alkaline solution). Polyvinyl alcohol or polyvinyl pyrrolidone is preferably used in the protective layer. Polyvinyl alcohol has the effect of preventing oxygen from transmitting and polyvinyl pyrrolidone has the effect of increasing adhesion between the oxygen shielding layer and the light sensitive layer.

Besides the above two polymers, the oxygen shielding layer may contain a water soluble polymer such as polysaccharide, polyethylene glycol, gelatin, glue, casein, hydroxyethyl cellulose, carboxymethyl cellulose, methyl cellulose, hydroxyethyl starch, gum arabic, sucrose octacetate, ammonium alginate, sodium alginate, polyvinyl amine, polyethylene oxide, polystyrene sulfonic acid, polyacrylic acid, or a water soluble polyamide.

In the planographic printing plate material in the invention, adhesive strength between the protective layer and the light sensitive layer is preferably not less than 35 mN/mm, more preferably not less than 50 mN/mm, and still more preferably not less than 75 mN/mm. Preferred composition of the protective layer is disclosed in Japanese Patent Application No. 8-161645.

The adhesive strength can be determined according to the following method. The adhesive tape with a sufficient adhesive force is applied on the protective layer, and then peeled together with the protective layer under the applied tape in the normal direction relative to the protective layer surface. Force necessary to peel the tape together with the protective layer is defined as adhesive strength.

The protective layer may further contain a surfactant or a matting agent. The protective layer is formed, coating on the photopolymerizable light sensitive layer a coating solution in which the above protective layer composition is dissolved in an appropriate coating solvent, and drying. The main solvent of the coating solution is preferably water or an alcohol solvent such as methanol, ethanol, or isopropanol.

The thickness of the protective layer is preferably 0.1 to 5.0 µm, and more preferably 0.5 to 3.0 µm.

### (Support)

The support used in the invention is a plate or a sheet capable of carrying the light sensitive layer and preferably has a hydrophilic surface on the side on which the light sensitive layer is to be provided.

As the supports used in the invention, a plate of a metal such as aluminum, stainless steel, chromium or nickel, or a plastic film such as a polyester film, a polyethylene film or a polypropylene film, which is deposited or laminated with the above-described metal can be used.

Further, a polyester film, a polyvinyl chloride film or a nylon film whose surface is subjected to hydrophilization treatment can be used, and the aluminum support is preferably used.

As the aluminum support, a pure aluminum plate or an aluminum alloy plate is preferably used.

As the aluminum alloy for the support, there can be used various ones including an alloy of aluminum and a metal such as silicon, copper, manganese, magnesium, chromium, zinc, lead, bismuth, nickel, titanium, sodium or iron. In the aluminum plate for the support, the surface is roughened for water retention.

It is preferable that the aluminum plate is subjected to degreasing treatment for removing rolling oil prior to surface roughening (graining). The degreasing treatments include degreasing treatment employing solvents such as trichlene and thinner, and an emulsion degreasing treatment employing an emulsion such as kerosene or triethanol. It is also possible to use an aqueous alkali solution such as caustic soda for the degreasing treatment. When an aqueous alkali solution such as caustic soda is used for the degreasing treatment, it is possible to remove soils and an oxidized film which can not be removed by the above-mentioned degreasing treatment alone. When an aqueous alkali solution such as caustic soda is used for the degreasing treatment, the resulting support is preferably subjected to desmut treatment in an aqueous solution of an acid such as phosphoric acid, nitric acid, sulfuric acid, chromic acid, or a mixture thereof, since smut is produced on the surface of the support. The surface roughening methods include a mechanical surface roughening method and an electrolytic surface roughening method electrolytically etching the support surface.

Though there is no restriction for the mechanical surface roughening method, a brushing roughening method and a honing roughening method are preferable.

Though there is no restriction for the electrolytic surface roughening method, a method, in which the support is electrolytically surface roughened in an acidic electrolytic solution, is preferred.

After the support has been electrolytically surface roughened, it is preferably dipped in an acid or an aqueous alkali solution in order to remove aluminum dust, etc. produced in the surface of the support. Examples of the acid include sulfuric acid, persulfuric acid, hydrofluoric acid, phosphoric acid, nitric acid and hydrochloric acid, and examples of the alkali include sodium hydroxide and potassium hydroxide. Among those mentioned above, the aqueous alkali solution is preferably used.

The dissolution amount of aluminum in the support surface is preferably 0.5 to 5 g/m². After the support has been dipped in the aqueous alkali solution, it is preferable for the support to be dipped in an acid such as phosphoric acid, nitric acid, sulfuric acid and chromic acid, or in a mixed acid thereof, for neutralization.

The mechanical surface roughening and electrolytic surface roughening may be carried out singly, and the mechanical surface roughening followed by the electrolytic surface roughening may be carried out.

After the surface roughening, anodizing treatment may be carried out. There is no restriction in particular for the method of anodizing treatment used in the invention, and known methods can be used. The anodizing treatment forms an anodization film on the surface of the support.

The support which has been subjected to anodizing treatment is optionally subjected to sealing treatment. For the sealing treatment, it is possible to use known methods using hot water, boiling water, steam, a sodium silicate solution, an aqueous dichromate solution, a nitrite solution and an ammonium acetate solution.

After the above treatment, the support is suitably undercoated with a water soluble resin such as polyvinyl phosphonic acid, a polymer or copolymer having a sulfonic acid in the side chain, or polyacrylic acid; a water soluble metal salt such as zinc borate; a yellow dye; an amine salt; and so on, for hydrophilization treatment. The sol-gel treatment support disclosed in Japanese Patent O.P.I. Publication No. 5-304358, which has a functional group capable of causing addition reaction by radicals as a covalent bond, is suitably used.

### (Coating)

In the invention, the above-described light sensitive layer coating solution is coated on the support according to a coating conventional method, and dried to obtain a light sensitive planographic printing plate material.

Examples of the coating method include an air doctor coating method, a blade coating method, a wire bar coating method, a knife coating method, a dip coating method, a reverse roll coating method, a gravure coating method, a cast coating method, a curtain coating method, and an extrusion coating method.

A drying temperature of the coated light sensitive layer is preferably from 60 to 160 °C, more preferably from 80 to 140 °C, and still more preferably from 90 to 120 °C.

### (Imagewise Exposure)

As a light source for recording an image on the light sensitive planographic printing plate material of the invention, a laser with an emission wavelength of from 350 to 450 nm is preferably used.

Examples of light sources for imagewise exposure of the light sensitive planographic printing plate material include a He-Cd laser (441 nm), a combination of Cr:LiSAF and SHG crystals (430 nm) as a solid laser, and KnbO3, ring resonator (430 nm), AlGaInN (350-350 nm) or AlGaInN semiconductor laser (InGaN type semiconductor laser available on the market, 400-410 nm) as a semiconductor type laser.

When a laser is used for exposure, which can be condensed in the beam form, scanning exposure according to an image can be carried out, and direct writing is possible without using any mask material.

When the laser is employed for imagewise exposure, a highly dissolved image can be obtained, since it is easy to condense its exposure spot in minute size.

As a laser scanning method by means of a laser beam, there are a method of scanning on an outer surface of a cylinder, a method of scanning on an inner surface of a cylinder and a method of scanning on a plane. In the method of scanning on an outer surface of a cylinder, laser beam exposure is conducted while a drum around which a recording material is wound is rotated, in which main scanning is represented by the rotation of the drum, while sub-scanning is represented by the movement of the laser beam. In the method of scanning on an inner surface of a cylinder, a recording material is fixed on the inner surface of a drum, a laser beam is emitted from the inside, and main scanning is carried out in the circumferential direction by rotating a part of or an entire part of an optical system, while sub-scanning is carried out in the axial direction by moving straight a part of or an entire part of the optical system in parallel with a shaft of the drum. In the method of scanning on a plane, main scanning by means of a laser beam is carried out through a combination of a polygon mirror, a galvano mirror and an Fθ lens, and sub-scanning is carried out by moving a recording medium. The method of scanning on an outer surface of a cylinder and the method of scanning on an inner surface of a cylinder are suitable for high density image recording, since it is easier to increase accuracy of an optical system.

In the invention, imagewise exposure is carried out at a plate surface energy (an exposure energy at the surface of the planographic printing plate material) of from 10 to 500 mJ/cm², and more preferably from 10 to 300 mJ/cm². This exposure energy can be measured, employing a laser power meter PDGDO-3W produced by Ophir Optronics Inc.

### (Developer)

In the manufacturing method of the invention of a planographic printing plate, the imagewise exposed light sensitive layer, which has been cured at exposed portions, is developed with an alkali developer, whereby the light sensitive layer at exposed portions are removed to form an image.

As the alkali developer, a conventional alkali aqueous solution is used. For example, there is an alkali developer containing an inorganic alkali agent such as sodium silicate, potassium silicate, ammonium silicate, sodium secondary phosphate, potassium secondary phosphate, ammonium secondary phosphate; sodium hydrogen carbonate, potassium hydrogen carbonate, ammonium hydrogen carbonate; sodium carbonate, potassium carbonate, ammonium carbonate; sodium borate, potassium borate, lithium borate; sodium hydroxide, potassium hydroxide, and ammonium hydroxide.

The alkali developer can contain organic alkali agents such as monomethylamine, dimethylamine, trimethylamine, monoethylamine, diethylamine, triethylamine, monoisopropylamine, diisopropylamine, triisopropylamine, n-butylamine, monoethanolamine, diethanolamine, triethanolamine, monoisopropanolamine, diisopropanolamine, ethyleneimine, ethylenediamine, and pyridine.

These alkali agents can be used singly or as a mixture of two or more thereof. The alkali developer can contain an anionic surfactant, an amphoteric surfactant, or an organic solvent such as alcohol.

The alkali developer can be prepared from a developing composition in the form of tablets or granules or a developer concentrate.

The developer concentrate may be prepared by forming a developer solution, followed by evaporation to dryness and is preferably prepared in such a manner that plural components are mixed with a small amount of water or without adding any water. The developer concentrate can also be prepared in the form of granules or tablets, as described in Japanese Patent O.P.I. Publication Nos. 51-61837, 2-109042, 2-109043, 3-39735, 5-142786, 6-266062 and 7-13341. The developer concentrate may be divided into plural parts differing in material species or compounding ratio.

The developer or developer replenisher in the invention can further contain an antiseptic agent, a coloring agent, a viscosity increasing agent, an antifoaming agent, or a water softener.

### (Automatic developing machine)

It is advantageous that an automatic developing machine is used in order to develop a light sensitive planographic printing plate material. It is preferred that the automatic developing machine is equipped with a means for automatically introducing a developer replenisher in a necessary amount into a developing bath, a means for discharging any excessive developer and a means for automatically introducing water in necessary amounts to the developing bath. It is preferred that the automatic developing machine comprises a means for detecting a planographic printing plate material to be transported, a means for calculating the area to be processed of the planographic printing plate material based on the detection, or a means for controlling a replenishing amount of a developer replenisher, a replenishing amount of water to be replenished or replenishing timing based on the detection and calculation. It is also preferred that the automatic developing machine comprises a means for controlling a temperature of a developer, a means for detecting a pH and/or electric conductivity of a developer, or a means for controlling a replenishing amount of the developer replenisher, a replenishing amount of water to be replenished and/or the replenishing timing based on the detected pH and/or electric conductivity. It is also preferred that the automatic developing machine have a function of diluting a developer concentrate with water and a function of stirring the diluted concentrate. Where developing is followed by washing, water used for washing can be reused as a dilution water for diluting the developer concentrate.

The automatic developing machine used in the invention may be provided with a pre-processing section to allow the plate to be immersed in a pre-processing solution prior to development. The pre-processing section is provided preferably with a mechanism of spraying a pre-processing solution onto the plate surface, preferably with a mechanism of controlling the pre-processing solution at a temperature within the range of 25 to 55 °C, and preferably with a mechanism of rubbing the plate surface with a roller-type brush. Common water and the like are employed as the pre-processing solution.

### (Post-processing)

The developed printing plate material is preferably subjected to post-processing. The post-processing step comprises post-processing the developed precursor with a post-processing solution such as washing water, a rinsing solution containing a surfactant, a finisher or a protective gumming solution containing gum arabic or starch derivatives as a main component. The post-processing step is carried out employing an appropriate combination of the post-processing solution described above. For example, a method is preferred in which a developed planographic printing plate precursor is post-washed with washing water, and then processed with a rinsing solution containing a surfactant, or a developed planographic printing plate precursor is post-washed with washing water, and then processed with a finisher, since it reduces fatigue of the rinsing solution or the finisher. It is preferred that a multi-step countercurrent processing is carried out employing a rinsing solution or a finisher.

The post-processing is carried out employing an automatic developing machine having a development section and a post-processing section. In the post-processing step, the developed printing plate is sprayed with the post-processing solution from a spray nozzle or is immersed into the post-processing solution in a post-processing tank. A method is known in which supplies a small amount of water onto the developed printing plate precursor to wash the precursor, and reuses the water used for washing as dilution water for developer concentrate. In the automatic developing machine, a method is applied in which each processing solution is replenished with the respective processing replenisher according to the area of the printing plate precursor to have been processed or the operating time of the machine. A method (use-and-discard method) can be applied in which the developed printing plate material is processed with fresh processing solution and discarded. The thus obtained planographic printing plate is mounted on a printing press, and printing is carried out.

### EXAMPLES

Next, the present invention will be explained in the following examples, but the present invention is not limited thereto. In the examples, "parts" represents "parts by weight", unless otherwise specified.

### [Polymeric Binder: Synthesis of Acryl Copolymer 1]

Thirty parts of methacrylic acid, 50 parts of methyl methacrylate, 20 parts of ethyl methacrylate, 200 parts of isopropyl alcohol, 300 parts of propylene glycol methyl ether acetate and 3 parts of α,α'-azobisisobutyro-nitrile were put in a three neck flask under nitrogen atmosphere, and reacted under nitrogen atmosphere for 6 hours at 80°C in an oil bath.

After that, the reaction mixture was refluxed at a boiling point of isopropyl alcohol for one hour, and 3 parts of triethylammonium chloride and 25 parts of glycidyl methacrylate were further added to the mixture, and reacted for additional 3 hours to obtain a 20% by weight solution of acryl copolymer 1. The weight average molecular weight of the acryl copolymer 1 was 40,000, measured according to GPC. The glass transition temperature Tg of the acryl copolymer 1 was 85 °C, measured according to DSC (differential thermal analysis).

### [Preparation of Support]

A 0.30 mm thick and 1030 mm wide aluminum plate (material JIS A 1050) was successively treated according to the following procedures:
(a) The aluminum plate was subjected to etching treatment, in which the aluminum plate was sprayed with a 70 °C solution having a caustic soda concentration of 2.6 weight% and an aluminum ion concentration of 6.5 weight% to dissolve the aluminum by 0.3 g/m², and was washed by means of a water spray.
(b) Desmut treatment was performed by spraying the aluminum plate with an aqueous 1% by weight nitric acid solution (containing aluminum ion of 0.5 weight%) at 30 °C, followed by washing by water spraying.
(c) The resulting aluminum plate was subjected to continuous electrolytic roughening treatment, utilizing an alternating voltage of 60 Hz, in a 21 °C electrolytic solution containing 1.1% by weight hydrochloric acid, 0.5% by weight of an aluminum ion and 0.5% by weight of acetic acid.
   The electrolytic roughening treatment was performed employing a sine wave alternating current at a TP (time taken for current to reach from zero to the peak value) of 2 msec, and employing a carbon electrode as a counter electrode.
   The current density was 50 A/dm² in terms of effective value, and the quantity of electricity supplied was 900 C/dm². Thereafter, the plate was washed by spraying water.
(d) The resulting aluminum plate was desmutted for 10 seconds in an aqueous 20% by weight phosphoric acid solution having an aluminum ion concentration of 0.5% by weight at 60 °C, and washed with water spray.
(e) Employing a conventional anodizing treatment apparatus employing a two-step power-supplied electrolysis method (in which a length of each of the first and second electrolysis section is 6 m, the first power supply section is 3 m long, the second power supply section is 3 m long, and a length of each of the first and second power supply electrodes is 2.4 m), anodizing treatment was performed at 38 °C in a solution having a sulfuric acid concentration of 170 g/l (having an aluminum ion concentration of 0.5 weight%) in the electrolysis section. Thereafter, the plate was sprayed with water and washed.

At this time, in the anodizing treatment apparatus, electric current from power source flowed to the first power supply electrode arranged in the first power supply section, then to the aluminum plate through the electrolytic solution to form an oxidized film on the surface of the aluminum plate in the first electrolysis section, and passed through the electrolysis electrode arranged in the first power supply section to return to the power source.

On the other hand, electric current from a power source flowed to the second power supply electrode arranged in the second power supply section, then similarly to the aluminum plate through the electrolytic solution to form an oxidized film on the surface of the aluminum plate in the second electrolysis section. The quantity of electricity supplied from a power source to the first power supply section and the quantity of electricity supplied from a power source to the second power supply section were same, and the power supply electric current density on the oxidized film surface at the second power supply section was approximately 25 A/dm². In the second power supply section, power was supplied from the surface of the oxidized film of 1.35 g/m².

The final amount of the oxidized film was 2.7 g/m². The resulting aluminum plate was washed with water, then subjected to hydrophilization treatment in which the plate was immersed in a 85 °C aqueous 0.4% by weight polyvinyl phosphonic acid solution for 30 seconds, washed with water, and dried with an infrared heater.

The aluminum support obtained above had a centerline average surface roughness (Ra) of 0.65 µm.

### [Preparation of Light Sensitive Planographic Printing Plate Material Samples]

The following photopolymerizable light sensitive layer coating solution was coated on the resulting support through a wire bar, and dried at 95 °C for 1.5 minutes to give a photopolymerizable light sensitive layer having a dry thickness of 1.5 g/m².

After that, the following oxygen shielding layer coating solution was coated on the photopolymerizable light sensitive layer using a wire bar, and dried at 75 °C for 1.5 minutes to give an oxygen shielding layer with a dry thickness of 1.8 g/m². Thus, a light sensitive planographic printing plate material samples 1 through 24 were prepared.

**(Photopolymerizable Light Sensitive Layer Coating Solution)**

| | |
|---|---|
| Ethylenically unsaturated compound 1 | 7.0 parts |
| Ethylenically unsaturated compound 2 | 10.0 parts |
| Ethylenically unsaturated compound (NK OLIGO U-4HA, produced by Shinnakamura Kagaku Co., Ltd) | 10.0 parts |
| Ethylenically unsaturated compound (NK ESTER 4G, produced by Shinnakamura Kagaku Co., Ltd) | 14.0 parts |
| Spectral Sensitizing Dye (as shown in Table 1) | 3.0 parts |
| Photopolymerization initiator (as shown in Table 1) | 8.0 parts |
| 2-Mercaptobenzothiazole | 1.0 parts |
| 20% by weight solution of Acryl copolymer 1 (45.0 parts in terms of solid content) | 225.0 parts |
| 35% by weight MEK dispersion of phthalocyanine pigment (MHI 454, produced by Mikuni Shikiso Co., Ltd.) (6.0 parts in terms of solid content) | 17.14 parts |
| 2-t-Butyl-6-(3-t-butyl-2-hydroxy-5-methylbenzyl)-4-methylphenylacrylate (Sumirizer GS: produced by Sumitomo 3M Co., Ltd.) | 0.5 parts |
| 2,4,6-Tris(dimethylaminomethyl)phenol | 1.0 parts |
| Bis(2,2,6,6-tetramethyl-4-piperidyl)sebacate | 0.1 parts |
| Fluorine-contained surfactant (FC-4430: produced by Sumitomo 3M Co., Ltd.) | 0.5 parts |
| Methyl ethyl ketone | 80 parts |
| Cyclohexanone | 820 parts |
| Ethylenically unsaturated compound 1: Reaction product of butyldiethanolamine (1 mole), toluene diisocyanate (2 moles) and 2-hydroxyethyl methacrylate (2 moles) | |
| Ethylenically unsaturated compound 1 Reaction product of 2-hydroxyethylpiperidine (1 mole), hexamethylene diisocyanate (2 moles) and 2-hydroxyethyl methacrylate (2 moles) | |

| (Oxygen shielding layer coating solution) | |
|---|---|
| Polyvinyl alcohol (AL-06, produced by Nippon Gosei Kagaku Co., Ltd.) | 84 parts |
| Polyvinyl Pyrrolidone (PVP Luvitec K-30, produced by BASF Co., Ltd.) | 10 parts |
| Polyethylene imine (Lupasol WF, produced by BASF Co., Ltd.) | 5 parts |
| Surfactant (Surfinol 465, produced by Nisshin Kagaku Kogyo Co., Ltd.) | 0.5 parts |
| Water | 900 parts |

### (Evaluation of Light Sensitive Planographic Printing Plate Material)

### (Sensitivity)

Employing a plate setter (Mako 4 produced by ECRM Co., Ltd.) installed with a 60 mW light source emitting a 405 nm light, the light sensitive planographic printing plate material obtained above was imagewise exposed at a resolving degree of 2400 dpi. Herein, dpi represents the dot numbers per 2.54 cm.

The image pattern used for the exposure comprised a 100 % solid image, and a 50% square dot with a screen line number of 175.

Subsequently, the exposed sample was subjected to development treatment employing a CTP automatic developing machine (Raptor Polymer produced by Glunz & Jensen Inc.) to obtain a planographic printing plate. Herein, the developing machine comprised a preheating section set at 105 °C, a pre-washing section for removing the oxygen shielding layer before development, a development section set at 30 °C and charged with developer having the following developer composition, a washing section for removing the developer remaining on the developed sample after development, and a gumming section charged with a gumming solution (a solution obtained by diluting GW-3, produced by Mitsubishi Chemical Co., Ltd., with water by a factor of 2) for protecting the surface of the developed sample. Thus, planographic printing plate was obtained.

The minimum exposure energy (µJ/cm²), at which no thickness reduction of the solid image layer of the resulting printing plate obtained was observed, was defined as recording energy and evaluated as a measure of sensitivity.

The less the recording energy is, the higher the sensitivity. The results are shown in Table 1.

**Developer having the following composition (Aqueous solution containing the following components)**

| | |
|---|---|
| Potassium silicate A | 8.0 parts |
| Surfactant Newcol B-13SN (produced by Nippon Nyukazai Co., Ltd.) | 2.0 parts |
| Surfactant Pronon #204 (produced by Nippon Yushi Co., Ltd.) | 1.0 part |
| Potassium hydroxide | amount giving pH 12.3 |

### (Sensitivity after storage)

The printing plate material sample obtained above was packed in a light-shielding package and stored at 55 °C for two days in a thermostat. Sensitivity of the resulting sample was determined in the same manner as above.

### (Safelight Property)

The planographic printing plate material sample was placed under a fluorescent light with a yellow filter V10 (produced by Encapsulite Co., Ltd), and exposed to illuminance of 300 lux. The exposed sample was developed in the same manner as above. The maximum exposure time at which fog was not produced was determined as a safelight time, and evaluated as a measure of safelight property. The results are shown in Table 1.

As is apparent from Table 1, inventive planographic printing plate material samples high sensitivity and storage stability, maintaining excellent safelight property.

**Table 1**

| Light sensitive planographic printing plate material No. | Spectral Sensitizing Dye | Photopolymerization Initiator | Sensitivity (µJ/cm²) | Sensitivity after Storage (µJ/cm²) | Safelight Property | Remarks |
|---|---|---|---|---|---|---|
| 1 | D-1 | I-1-1 | 20 | 30 | 150 | Inv. |
| 2 | D-1 | I-1-10 | 20 | 30 | 150 | Inv. |
| 3 | D-1 | I-2-1 | 15 | 25 | 150 | Inv. |
| 4 | D-1 | I-2-5 | 15 | 25 | 150 | Inv. |
| 5 | D-1 | I-3-1 | 15 | 25 | 150 | Inv. |
| 6 | D-1 | I-3-8 | 15 | 25 | 150 | Inv. |
| 7 | D-1 | I-3-10 | 15 | 25 | 150 | Inv. |
| 8 | D-2 | I-1-1 | 20 | 25 | 140 | Inv. |
| 9 | D-2 | I-1-10 | 20 | 20 | 140 | Inv. |
| 10 | D-2 | I-2-1 | 15 | 20 | 140 | Inv. |
| 11 | D-2 | I-2-5 | 15 | 20 | 140 | Inv. |
| 12 | D-2 | I-3-1 | 15 | 15 | 140 | Inv. |
| 13 | D-2 | I-3-8 | 15 | 20 | 140 | Inv. |
| 14 | D-2 | I-3-10 | 15 | 15 | 140 | Inv. |
| 15 | D-3 | I-1-1 | 15 | 20 | 150 | Inv. |
| 16 | D-3 | I-1-10 | 15 | 15 | 150 | Inv. |
| 17 | D-3 | I-2-1 | 10 | 15 | 150 | Inv. |
| 18 | D-3 | I-2-5 | 10 | 15 | 150 | Inv. |
| 19 | D-3 | I-3-1 | 10 | 10 | 150 | Inv. |
| 20 | D-3 | I-3-8 | 10 | 10 | 150 | Inv. |
| 21 | D-3 | 1-3-10 | 10 | 10 | 150 | Inv. |
| 22 | D-1 | *I-ref | 45 | 120 | 120 | Comp. |
| 23 | D-2 | *I-ref | 50 | 100 | 120 | Comp. |
| 24 | D-3 | *I-ref | 50 | 110 | 120 | Comp. |

| | | | | | | |
|---|---|---|---|---|---|---|
| Inv.: Inventive, Comp.: Comparative *I-ref: 2,2'-Di(2-chlorophenyl)-4,4',5,5'-tetraphenyl-bisimidazole | | | | | | |

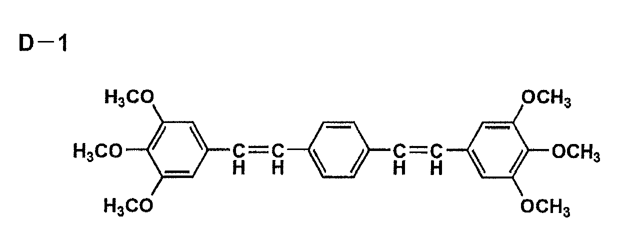

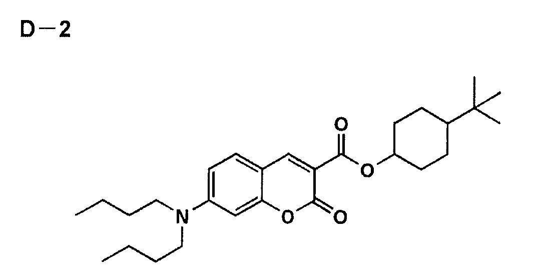

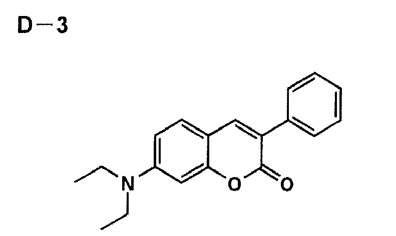

## Claims

1. A light sensitive planographic printing plate material comprising a support and provided thereon, a light sensitive layer containing a photopolymerization initiator (A), a polymerizable ethylenically unsaturated compound (B), a dye (C) having absorption maximum in the wavelength regions of from 350 to 450 nm, and a polymeric binder (D), the light sensitive planographic printing plate material being **characterized in that** the light sensitive layer contains a compound represented by the following formula (1) as the photopolymerization initiator (A), 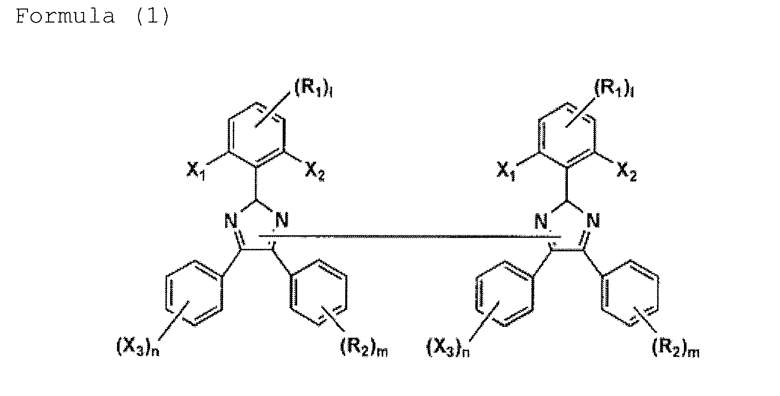 wherein X₁ and X₂ independently represent a hydrogen atom or a halogen atom, provided that at least one of X₁ and X₂ is a halogen atom; X₃ represents a halogen atom; n is an integer of from 1 to 5; R₁ represents a monovalent substituent; 1 is an integer of from 0 to 3; R₂ represents a monovalent substituent; and m is an integer of 0 or 1.

2. The light sensitive planographic printing plate material of claim 1, wherein in formula (1), R₂ is an alkyl group or an alkoxy group.

3. The light sensitive planographic printing plate material of claim 2, wherein in formula (1), X₁ is a chlorine atom; X₂ is a hydrogen atom; and X₃ is a chlorine atom.

4. The light sensitive planographic printing plate material of any one of claims 1 through 3, wherein the dye (C) having absorption maximum in the wavelength regions of from 350 to 450 nm is a compound represented by the following formula (2), 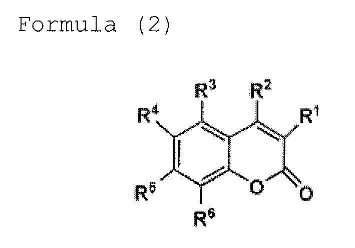 wherein R¹ through R⁶ independently represent a hydrogen atom, an alkyl group, a cycloalkyl group, an aryl group, an alkenyl group, an alkinyl group, a heterocyclic group, an alkoxy group, a cycloalkoxy group, an aryloxy group, an alkylthio group, a cycloalkylthio group, an arylthio group, an alkoxycarbonyl group, an aryloxycarbonyl group, a sulfamoyl group, an acyl group, an amido group, a carbamoyl group, a ureido group, an alkylsulfonyl group, an arylsulfonyl group, an amino group, a halogen atom, a cyano group, a nitro group or a hydroxyl group.
